# FASCICULE DE BREVET EUROPEEN

(11) **EP 2 580 785 B1**
(45) Date de publication et mention de la délivrance du brevet: **21.05.2014**
(21) Numéro de dépôt: 11729735.8
(22) Date de dépôt: 07.06.2011
(51) Int. Cl.: H01L 31/0264, H01L 31/0352, H01L 31/0384, H01L 27/146, H01L 29/15

(54) **MATÉRIAU NANOCOMPOSITE ET SON UTILISATION EN OPTO-ÉLECTRONIQUE**
NANOVERBUNDMATERIAL UND SEINE VERWENDUNG IN DER OPTOELEKTRONIK
NANOCOMPOSITE MATERIAL AND ITS USE IN OPTOELECTRONICS

(30) Priorité: 08.06.2010 FR 1002410
(43) Date de publication de la demande: 17.04.2013
(73) Titulaire: Commissariat à l'Énergie Atomique et aux Énergies Alternatives, 75015 Paris (FR)
(72) Inventeur: QUESNEL, Etienne, F-38240 Meylan (FR)
(74) Mandataire: Majidi, Assieh
(86) Numéro de dépôt international: PCT/IB2011/052476
(87) Numéro de publication internationale: WO 2011/154896

(56) Documents cités:
- US-A1- 2007 128 439
- QUESNEL E ET AL: "Modeling metallic nanoparticle synthesis in a magnetron-based nanocluster source by gas condensation of a sputtered vapor", JOURNAL OF APPLIED PHYSICS, AMERICAN INSTITUTE OF PHYSICS. NEW YORK, US, vol. 107, no. 5, 4 mars 2010 (2010-03-04), pages 54309-54309, XP012133617, ISSN: 0021-8979, DOI: DOI:10.1063/1.3310420
- LAW M ET AL: "ZNO-AL2O3 AND ZNO-TIO2 CORE-SHELL NANOWIRE DYE-SENSITIZED SOLAR CELLS", JOURNAL OF PHYSICAL CHEMISTRY. B, MATERIALS, SURFACES, INTERFACES AND BIOPHYSICAL, WASHINGTON, DC, US, vol. 110, no. 45, 16 novembre 2006 (2006-11-16), pages 22652-22663, XP008077469, ISSN: 1089-5647, DOI: DOI:10.1021/JP0648644
- PRASHANT V KAMAT: "Quantum Dot Solar Cells. Semiconductor Nanocrystals as Light Harvesters", JOURNAL OF PHYSICAL CHEMISTRY, vol. 112, no. 48, 18 octobre 2008 (2008-10-18), pages 18737-18753, XP007916741, ISSN: 0022-3654 [extrait le 2008-10-18]

## Description

L'invention a pour objet de nouveaux matériaux nano-composites, un procédé pour leur fabrication et leurs utilisations, notamment comme absorbeur opto-électronique. En particulier, le matériau de l'invention peut être utilisé pour fabriquer des cellules photovoltaïques ou tout type de système opto-électronique utilisant un matériau absorbeur pour la conversion de photons en courant électrique.

L'invention concerne le domaine des composants opto-électroniques, c'est-à-dire des composants électroniques qui émettent de la lumière ou qui interagissent avec la lumière.

Une cellule photovoltaïque est un composant électronique qui, exposé à la lumière (photons), génère de l'électricité. Le courant obtenu est fonction de la lumière incidente. L'électricité produite est fonction de l'éclairement.

Les cellules photovoltaïques sont souvent réunies dans des modules solaires photovoltaïques ou panneaux solaires, leur nombre étant adapté en fonction de la puissance électrique attendue.

Les cellules photovoltaïques les plus répandues sont constituées de semi-conducteurs, principalement à base de silicium (Si) et parfois d'autres semi-conducteurs tels que le sélénure de cuivre et d'indium (CuIn(Se)₂ ou CuInGa(Se)₂), le tellurure de cadmium (CdTe). Elles se présentent généralement sous la forme de fines plaques dont la largeur est d'environ une dizaine de centimètres de côté, placées entre deux contacts métalliques, l'ensemble présentant une épaisseur de l'ordre du millimètre. Une cellule photovoltaïque peut être constituée de plusieurs matériaux assemblés dans diverses configurations. On désigne du nom de matériau actif le matériau absorbant qui transforme la lumière en porteurs électron-trou.

On connaît à l'heure actuelle trois générations de cellules photovoltaïques:

La première génération dont le matériau actif est à base de silicium mono- ou poly-cristallin. La seconde génération développée sur la base de couches minces (matériau actif: silicium amorphe, polymorphe ou micro-cristallisé ; CIGS, CdTe, ..). La troisième génération qui dérive directement de la précédente mais qui inclut des concepts avancés de piégeage de la lumière.

Ces concepts visent à renforcer le piégeage de la lumière par différentes méthodes que l'on peut classer comme suit :
(i) accroissement de la diffusion optique de la lumière incidente,
(ii) augmentation de l'absorption optique du matériau actif par génération d'effet plasmon dans cette couche de matériau, ou encore
(iii) adaptation du matériau actif au spectre solaire.

Suivant cette troisième approche, l'adaptation du matériau actif au spectre solaire repose souvent sur l'utilisation de multi-jonctions, chaque jonction étant destinée à absorber une gamme spectrale particulière du soleil. C'est le cas par exemple des bi- ou tri-jonctions dites III-V (King et al, Applied Physics Letters 90, 183516, (2007)), dont la combinaison absorbe au final la majeure partie du spectre solaire. Chaque matériau de la jonction a un gap optique particulier et absorbe dans une gamme spectrale donnée.

Suivant le même objectif d'adapter le matériau actif au spectre solaire, une autre approche consiste à moduler les domaines d'absorption en utilisant des nanoparticules semi-conductrices dont le gap optique dépend de la taille. Les nanoparticules semi-conductrices dont le diamètre est inférieur à 5 nm présentent généralement cette propriété. C'est le cas notamment des nanoparticules de silicium dont le gap optique croît de 1,1 à 2,5 eV lorsque la taille des cristallites décroit de 5 nm jusqu'à 3 nm. En général, pour permettre leur utilisation dans la fabrication de composants opto-électroniques, ces nanoparticules sont noyées dans une matrice diélectrique, l'ensemble formant un matériau nano-composite. En utilisant un empilement de différents matériaux nano-composites, chaque composite contenant des nanoparticules d'une taille donnée, on crée une cellule photovoltaïque multi-jonction qui interagit avec tous les photons du spectre solaire, quelles que soient leurs énergies.

Le document US 2007/128439 A1 (KIM SANG H [KR] ET AL KIM SANG HO [KR] ET AL) 7 juin 2007 (2007-06-07), qui est considéré comme l'état de la technique le plus proche de l'objet de l'invention présente, divulgue un matériau comportant des nanoparticules de type coeur-coquille, dont le coeur est constitué d'un matériau semi-conducteur choisi parmi les matériaux covalents Si, Ge et Si-Ge et les matériaux ioniques de type II-VI ou III-V et la coquille est formée d'un matériau choisi parmi les oxydes TiO₂ et/ou CeO₂.

En outre, le document Quesnel E. et al., "Modeling metallic nanoparticle synthesis in a magnetron-based nanocluster source by gas condensation of a sputtered vapor", Journal of Applied Physics, vol. 107, no. 5, 4 mars 2010 (2010-03-04), pages 54309-54309, XP012133617, divulgue un procédé pour la fabrication de nanoparticules qui comporte les étapes suivantes: production dans une source à nanoparticules d'une vapeur composée d'atomes de nanoparticules, formation de nanoparticules par condensation des atomes en phase gazeuse par refroidissement de la vapeur, transport des nanoparticules ainsi formées dans une enceinte de dépôt, projection sur un substrat.

L'utilisation de nanoparticules de silicium pour des applications photovoltaïques a été proposée il y a quelques années par M. Green et al., « All-silicon tandem cells based on « artificial » semiconductors synthesized using silicon quantum dots in a dielectric matrix », Proceedings of the 20th European Photovoltaïc Solar Energy Conference, Barcelona, June 2005, p.3 ». Ces nanoparticules de silicium sont connues sous le nom de « Quantum Dots ». De manière générale la technique de fabrication de ces nano-composites consiste à déposer sous vide une couche contenant du silicium en excès comme SiOₓ avec x<2, SiC_{y} avec y<1 ou encore SiN_{z} avec z<4/3. Par recuit de ces composés à haute température (1100°C), le silicium en excès précipite et forme des nano-cristaux de silicium. Une variante de cette technique consiste à déposer des multicouches alternant le dépôt de diélectrique et le dépôt de silicium pur (A.K. Dutta, Appl. Phys. Lett; 68, 9, (1996), 1189) ou de SiO (Zacharias et al, Applied Physics Letters, 80 (2002), p.661) en couches très fines (1-5 nm typ.) et de recuire l'ensemble. Ces techniques permettent donc de réaliser un nano-composite à base de nanoparticules ou de nano-cristaux de silicium (désignés de façon globale par le nom de quantum dots de Si) noyés dans une matrice de silice.

Des techniques semblables sont utilisées pour générer des nano-cristaux de germanium, le plus souvent par co-dépôt (A.K. Dutta, Appl. Phys. Lett; 68, 9, (1996), 1189; T.P. Leervadpedersen et al., Appl. Phys. A81, (2005),1591-93) en CVD ou en PVD (J. Skov Jensen et al, Appl. Phys. A83, (2006),41-8) d'un composé Si(₁₋ₓ)Geₓ suivi d'une étape de recuit, habituellement à une température comprise entre 800 et 1100°C pendant 0,5 à 2 heures. Le fonctionnement optoélectronique d'un tel matériau composite repose sur la photo-génération des porteurs de charge (électrons ou trous) dans les nanoparticules et la conduction à travers la matrice.

Si la matrice est en silice, cette conduction ne fonctionne que si les nanoparticules se touchent ou sont très proches les unes des autres. Pour améliorer cet aspect d'évacuation des charges électriques, une des solutions récemment proposées consiste à noyer les nanoparticules dans une matrice semi-conductrice de type SiC ou oxyde conducteur (ZnO, ITO, In₂O₃). Ces solutions sont actuellement à l'étude et leur faisabilité reste à démontrer. Au-delà des technologies de dépôt à mettre en oeuvre, on peut, en analysant la thermodynamique d'un tel système, prévoir une difficulté à contrôler l'interface entre la nanoparticule et la matrice dans le cas des oxydes conducteurs.

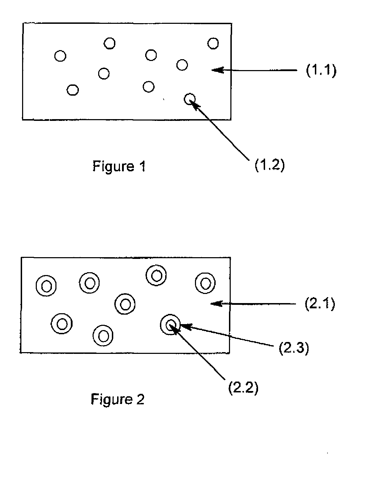

Le fondement de ces matériaux est une matrice d'oxydes conducteurs transparents tels que In₂O₃, ITO (In, Zn, O) ou ZnO, dopé ou non. Dans cette matrice, on insère des quantum dots ou nanoparticules semi-conductrices qui absorbent la lumière solaire et qui génèrent les paires e⁻-trou. Les tailles de ces nanoparticules varient de 1 à 30 nm de diamètre et préférentiellement de 1 à 15 nm pour conserver un effet de confinement quantique. Les matériaux constituant ces nanoparticules sont le plus souvent des semi-conducteurs covalents de type Si ou Ge ou leur alliage Si(₁₋ₓ) Geₓ. On pourrait également utiliser des matériaux ioniques dits «II-VI» comme CdTe, CdSe, ZnTe ou ZnSe, voire des «III-V» comme GaP, GaAs InSb, ... Dans tous les cas, la structure idéale que l'on a cherché à faire est la structure de la figure 1 dans laquelle (1.1) représente la matrice transparente conductrice et (1.2) représente les nanocristaux de silicium.

Si on se limite à l'utilisation de semi-conducteurs covalents, l'utilisation d'une technologie classique de précipitation de nanoparticules de Si, Ge ou de SiGe dans une matrice oxyde ne peut se faire qu'avec un recuit à plusieurs centaines de degrés. Ce recuit est par ailleurs indispensable pour obtenir des nano-cristaux semi-conducteurs présentant une absence de défauts électroniques (pièges à l'origine de la recombinaison des porteurs de charge) et une mobilité de porteurs acceptable pour l'application photovoltaïque. Dans ces conditions et du fait des propriétés thermodynamiques des constituants des nanocomposites ainsi formés, on aboutit inévitablement à déposer un composite formé de nano-cristaux de Si ou Ge ou de Si(₁₋ₓ) Geₓ. entourés d'une barrière isolante de leur oxyde, respectivement SiO₂, GeO₂ ou le mélange des deux. Ce résultat est schématisé sur la figure 2. Sur la figure 2, (2.1) représente la matrice transparente conductrice, (2.2) représente les nanocristaux de silicium et (2.3) représente SiO₂.

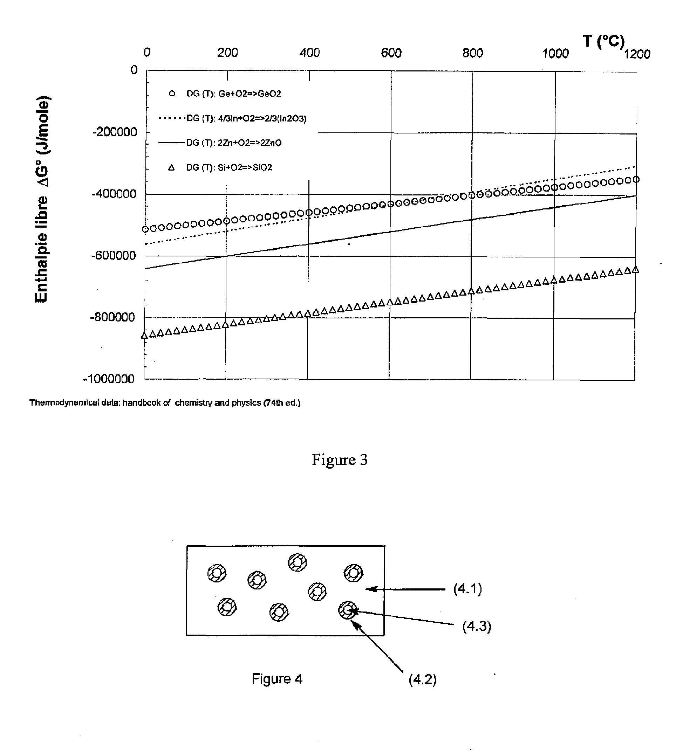

Cette oxydation résulte de l'équilibre thermodynamique entre les phases en présence que l'on évalue souvent au travers des diagrammes d'Ellingham. Sur la figure 3 sont représentés ces diagrammes pour les éléments Si, Ge, In et Zn. L'interprétation du diagramme est la suivante : si on met du germanium dans du ZnO ou dans de l'oxyde d'indium ou de l'ITO, on n'oxyde pas le germanium aux dépens des autres oxydes (courbe d'oxydation de Ge au dessus des courbes d'oxydation de l'indium et du zinc). Si la température excède 700-800°C, le germanium peut s'oxyder dans une matrice d'ITO.

En revanche, si on met du silicium dans les oxydes conducteurs à base de In₂O₃, ITO (In, Sn, O) ou ZnO, il s'oxyde quelle que soit la température de recuit.

Le gros inconvénient des solutions actuelles, au-delà des problèmes de transport électrique qu'elles peuvent engendrer, est que l'oxydation du quantum dot se fait en consommant de la matière semi-conductrice et donc en diminuant la taille du quantum dot. Or, comme cela a été expliqué ci-dessus c'est justement le contrôle de la taille des nanoparticules ou des nano-cristaux qui permet d'obtenir les propriétés souhaitées.

Contrôler la température de cristallisation du quantum dot (qui dépend de sa taille) et contrôler sa taille sachant qu'elle dépend de la cinétique d'oxydation et donc de la température est donc extrêmement difficile.

La présente invention remédie à ces problèmes en ayant mis au point de nouveaux matériaux à base de nanoparticules fonctionnalisées en surface et dispersées dans une matrice, cette fonctionnalisation permettant de stabiliser leur état d'oxydation tout en facilitant l'évacuation vers la matrice conductrice des charges électriques photo-générées dans les nanoparticules. L'invention porte plus particulièrement sur le matériau à base de ces nanoparticules et sur le procédé de préparation de ce matériau.

L'invention a pour premier objet un matériau comportant une matrice en matériau semi-conducteur ou isolant, transparent, dans laquelle sont dispersées des nanoparticules de type coeur-coquille, dont le coeur est constitué d'un matériau semi-conducteur choisi parmi les matériaux covalents Si, Ge ou Si-Ge et les matériaux ioniques de type II-VI ou III-V et la coquille est formée d'un matériau choisi parmi les oxydes TiO₂ et/ou CeO₂.

Par matériaux ioniques de type II-VI ou III-V on entend un alliage dont les composants sont choisis parmi les atomes des colonnes II et VI, ou respectivement parmi les colonnes III et V de la classification périodique des éléments.

Par matériau semi-conducteur ou isolant, on désigne également les oxydes transparents conducteurs.

La matrice peut notamment être en un matériau choisi parmi les oxydes semi-conducteurs ou isolants: SiO₂, SiC, SiNₓ (x≤4/3), In₂O₃, ITO (In, Zn, O) ou ZnO, dopé ou non. De préférence la matrice est en un matériau choisi parmi : ITO et ZnO.

Les nanoparticules ont une taille comprise entre 1 et 30 nm, de préférence entre 1 et 15 nm. Elles sont constituées d'un coeur dont la taille est comprise entre 1 et 25 nm et d'une coquille. La taille de la nanoparticule ou de son coeur est le plus grand diamètre de cet objet. La coquille fait préférentiellement entre 2 et 4 nm d'épaisseur.

Dans un matériau de l'invention, de préférence, les nanoparticules ont toutes un coeur dont la taille est sensiblement identique, c'est-à-dire qu'un diamètre moyen du coeur des nanoparticules est choisi et qu'au moins 90 % des particules du matériau présentent ce diamètre à ±20 % près.

Avantageusement, le coeur est constitué d'un matériau semi-conducteur choisi parmi : Si, Ge, Si(₁₋ₓ)Geₓ avec x un nombre et 0,1≤x≤0,9, les matériaux ioniques dits « II-VI » comme CdTe, CdSe, ZnTe ou ZnSe, les matériaux ioniques dits « III-V » comme GaP, GaAs InSb. De préférence le coeur est à base de Si, de Ge ou de Si(₁₋ₓ)Geₓ.

La coquille est formée d'un matériau choisi parmi les oxydes TiO₂, CeO₂, et leurs alliages.

Le matériau de l'invention est dit nano-composite ce qui signifie qu'il présente une structure composite (au moins deux matériaux distincts constituent, l'un la matrice, et l'autre les nanoparticules), l'un des matériaux étant présent sous forme d'une structure à l'échelle du nanomètre.

Comme dans les systèmes de quantum dots classiques, le gap optique est ajusté par la sélection de la taille des particules. Ainsi on peut fabriquer un matériau dont le gap optique est précisément fixé, et une superposition de couches de matériaux de l'invention ayant des gaps optiques distincts et déterminés permet d'obtenir un composant multi-jonction qui interagit avec tous les photons du spectre solaire, quelles que soient leurs énergies.

De façon avantageuse, la concentration des nanoparticules dans la matrice est comprise entre 10¹⁶ cm⁻³ et 10¹⁹ cm⁻³.

L'invention a donc également pour objet un article constitué d'une superposition de couches de matériaux de l'invention qui viennent d'être décrits ci-dessus.

De façon avantageuse, un tel article comporte de 1 à 10 couches de matériau de l'invention.

De façon avantageuse encore, les couches de matériau superposées comportent toutes des matrices d'un même matériau.

De façon encore plus avantageuse, les couches de matériau superposées sont toutes à base de nanoparticules de même matériau.

De façon avantageuse, chaque couche de matériau comporte des particules de taille distincte de celle des autres couches.

L'enrobage du coeur par les oxydes TiO₂ et CeO₂ (matériaux de la coquille) évite l'oxydation des nanoparticules de coeur, qu'elles soient en Si, Ge, SiGe ou autres.

Les matériaux de la présente invention sont représentés par la structure illustrée sur la figure 4. Sur la figure 4, (4.1) représente la matrice transparente conductrice, (4.3) représente les nanocristaux de silicium ou de germanium qui constituent le coeur des nanoparticules et (4.2) représente la coquille en TiO₂ ou en CeO₂.

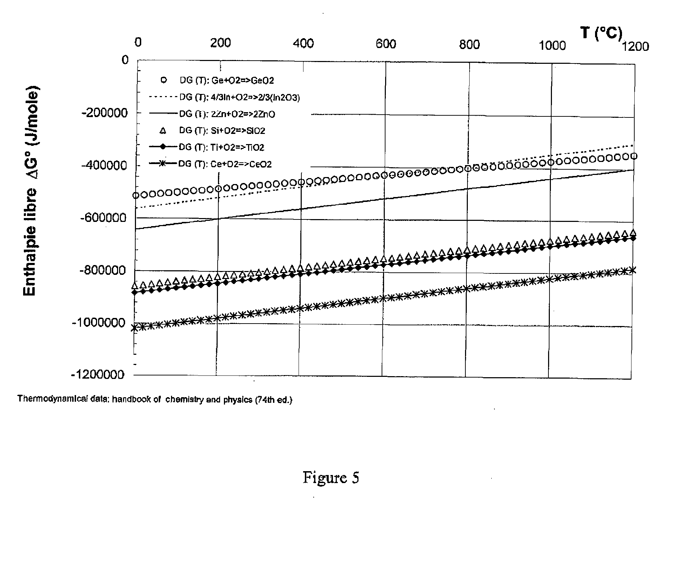

Les oxydes TiO₂ et CeO₂ sont stables par rapport aux semi-conducteurs Si, Ge et SiGe jusqu'à des températures très élevées, d'au moins 1200°C, comme on peut le constater sur le diagramme de la figure 5. C'est particulièrement vrai pour Ge. C'est également vrai par rapport aux principaux éléments métalliques constituant les semi-conducteurs II-VI et III-V.

Par ailleurs, ces couches de TiO₂ et/ou de CeO₂ sont aussi parfaitement stables par rapport à la matrice conductrice transparente (oxydes base In ou Zn). Elles le seront également par rapport à des matrices à base de Si, type SiO₂, SiC, SiNₓ.

En conséquence, pendant la phase de recuit de cristallisation des nanoparticules, les couches de TiO₂ ou de CeO₂ pompent l'oxygène résiduel piégé au coeur des nanoparticules et protègent ce même coeur de toute oxydation ultérieure par la matrice.

Du point de vue de leurs propriétés électriques, les données de conductivité électrique, bien que très dépendantes du mode de fabrication de la couche mince d'oxyde, permettent de classer les oxydes SiO₂, CeO₂, TiO₂ puis ITO et ZnO selon une résistivité décroissante. Autrement dit, dans le cas de nanoparticules de coeur à base de silicium, une structure selon l'invention telle qu'illustrée sur la figure 4 a de meilleures propriétés de transport de charges qu'une structure de l'art antérieur telle qu'illustrée sur la figure 2.

Du point de vue de leurs propriétés optiques, les oxydes TiO₂ et CeO₂, contrairement à SiO₂ par exemple, sont des matériaux à gap modéré (3eV). En éclairement à des longueurs d'ondes bleues ou ultraviolettes, ces matériaux deviennent plus ou moins conducteurs, ce qui favorise le transport des charges photo-générées par les nanoparticules et évite leur recombinaison.

**Tableau 1 : propriétés électriques et optiques des matériaux**

| | | | | | |
|---|---|---|---|---|---|
| Matrice | SiO₂ | TiO₂ | CeO₂ | ITO | ZnO |
| Resistivité (Ω.cm) | 10¹⁴ | 10² - 10⁵ | 10⁹ | 2.10⁻⁴ | 2.10⁻⁴ |
| Band gap | 9 eV | 3.26eV | 3.1eV | 3.8 eV* | 3.3 eV* |

L'invention a encore pour objet un procédé pour la fabrication des matériaux qui ont été décrits ci-dessus.

Le procédé de fabrication permet de synthétiser des particules semi-conductrices de type coeur-coquille, la coquille étant composée de TiO₂ et/ou CeO₂.

Pour éviter l'oxydation du coeur, on privilégie les techniques de synthèse sous vide bien que les voies humides puissent également être utilisées. Trois schémas de procédé sous vide sont proposés dans les modes opératoires ci-dessous.

Selon un premier procédé :
- production dans une source à nanoparticules d'une vapeur binaire composée d'atomes de coeur et, en moindre quantité (de 5 à 30% en moles d'atomes de coquille rapporté au nombre de moles d'atomes de coeur), d'atomes entrant dans la constitution de la coquille, c'est-à-dire d'atomes de Ti et/ou de Ce ;
- formation de nanoparticules par condensation des atomes en phase gazeuse par refroidissement de la vapeur ;
- transport des nanoparticules ainsi formées dans une enceinte de dépôt ;
- projection sur un substrat ;
- recuit à une température allant de 100°C à 700°C ;
- l'isolant ou le semi-conducteur constituant la matrice est déposé en même temps que les nanoparticules ou par alternance dans la même enceinte de dépôt sous vide.

Selon une variante, un autre procédé permettant d'obtenir les matériaux de l'invention comporte les étapes suivantes :
- dépôt alterné de couches très fines, de 0,2 à 5 nm, de matériau suivant la séquence : matériau de matrice / matériau coquille / matériau de coeur / matériau coquille / matériau de matrice ;
- répétition du dépôt alterné suivant la séquence ci-dessus de 10 à 100 fois, avec les mêmes matériaux de chaque catégorie ou des matériaux différents, en faisant éventuellement varier l'épaisseur de chaque matériau, en particulier du matériau de coeur, jusqu'à l'obtention d'un matériau d'épaisseur souhaitée.
- Recuit à une température allant de 800°C à 1000°C

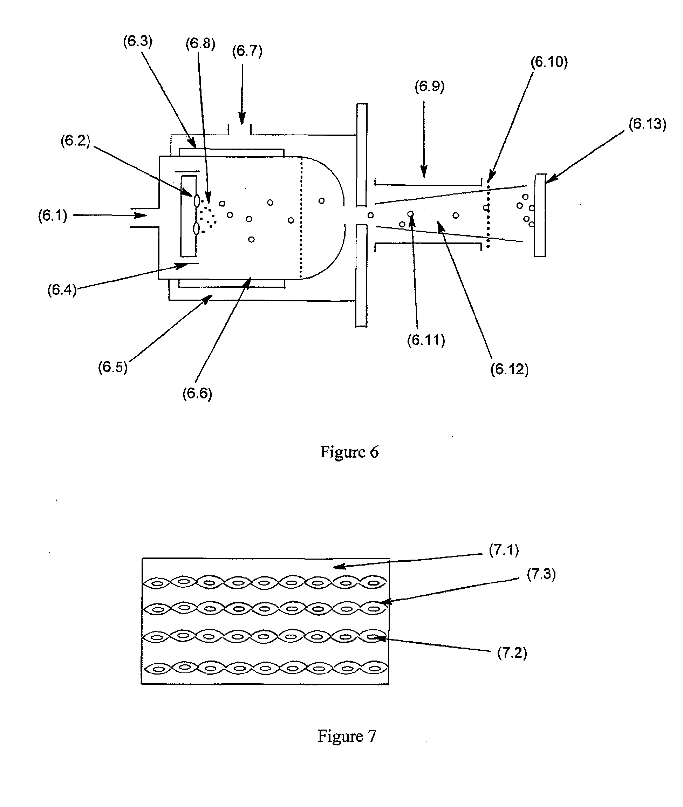

La couche de matériau coquille a pour effet de réduire l'atmosphère de dépôt de l'enceinte. Le recuit induit une précipitation du matériau de coeur sous forme de particules allongées dont la longueur est parfaitement contrôlée. Ce matériau de coeur est protégé par l'oxydation du matériau coquille et reste à l'état semi-conducteur. On obtient un produit qui est illustré sur la figure 7. Sur la figure 7, la matrice (7.1) de ZnO comporte des couches de nanoparticules (7.2) de Si enrobées de coquilles de (TiO₂) (7.3).

Selon une autre variante, les matériaux de l'invention peuvent être produits par un procédé qui comporte les étapes suivantes :
- production dans une source à nanoparticules d'une vapeur binaire composée d'atomes de coeur ;
- formation de nanoparticules par condensation des atomes en phase gazeuse par refroidissement de la vapeur ;
- transport des nanoparticules ainsi formées dans une enceinte de dépôt ;
- dépôt alterné de couches très fines, de 0,2 à 5 nm, de matériau suivant la séquence : matériau de matrice / matériau coquille / nanoparticules de coeur / matériau coquille / matériau de matrice ;
- recuit à une température allant de 100°C à 700°C.

Cette solution permet un bien meilleur contrôle de la taille des nanoparticules.

Les deux dernières variantes peuvent être réalisées par un procédé de dépôt chimique en phase vapeur (connu sous le nom de CVD).

Les avantages des matériaux composites de l'invention par rapport aux matériaux de l'art antérieur sont les suivants :
- Un meilleur contrôle de la taille des quantum dots insérés dans la matrice et donc un meilleur contrôle des caractéristiques d'absorption de l'absorbeur nanocomposite.
- Un meilleur contrôle de l'interface des quantum dots insérés dans la matrice et donc un meilleur contrôle des caractéristiques électriques de l'absorbeur nanocomposite utilisé en tant que générateur photo-électrique.

Les applications industrielles de l'invention sont les suivantes : fabrication de cellules photovoltaïques, fabrication de détecteurs ou d'imageurs opto-electroniques, fabrication de supports optiques et/ou magnétiques pour le stockage de données.

### FIGURES

Figure 1 : représentation schématique d'un matériau composite comprenant une matrice transparente conductrice et des nanocristaux de silicium.
Figure 2 : représentation schématique d'un matériau composite comprenant une matrice transparente conductrice, des nanocristaux de silicium entourés de SiO₂.
Figure 3 : diagrammes d'Ellingham pour les éléments Si, Ge, In et Zn (d'après le Handbook of Chemistry and Physics, 74ème édition).
Figure 4 : représentation schématique d'un matériau de l'invention comprenant une matrice transparente conductrice, des nanoparticules de nanocristaux de silicium ou de germanium enrobés d'une coquille en TiO₂ ou en CeO₂.
Figure 5 : diagramme illustrant l'enthalpie d'oxydation des matériaux Ti, Ce, Si, Ge, Zn, In en fonction de la température (d'après le Handbook of Chemistry and Physics, 74éme édition).
Figure 6 : représentation schématique d'une source à nanoparticules fonctionnant par pulvérisation
Figure 7 : représentation schématique d'un matériau multicouche selon l'invention.

### Exemples :

### Mode opératoire 1 : Synthèse directe de nano-cristaux de silicium fonctionnalisés suivie d'un recuit à 100-700°C.

Le principe consiste à générer dans une source à nanoparticules une vapeur binaire composée d'atomes de silicium et, en moindre quantité, d'atomes de Ti et/ou de Ce. Cette vapeur peut être produite par co-évaporation ou co-pulvérisation de 2 sources distinctes, l'une de Si et l'autre de Ti (et/ou Ce) ou par évaporation simple ou pulvérisation simple d'une source à deux ou trois éléments (Si+Ti, Si+Ce et Si+Ti+Ce). Les atomes sont ensuite condensés en phase gazeuse par refroidissement de la vapeur et les nanoparticules ainsi formées sont transportées dans l'enceinte de dépôt annexe pour être projetées sur le substrat à traiter. Un exemple de source à nanoparticules fonctionnant par pulvérisation est illustré sur la figure 6.

Sur la figure 6 un faisceau (6.12) de nanoparticules (6.11) est déposé sur un support (6.13). La source comprend une enceinte sous vide (6.6) dans laquelle est introduit un gaz plasmagène (6.1). Ce gaz s'ionise en surface de la cible (6.2) lors de l'application d'une tension continue entre (6.2) et (6.4) comme dans une cathode magnétron classique. Les ions ainsi formés sont accélérés vers la cible (6.2) et la pulvérisent, créant en retour la vapeur (6.8) de composition identique à celle de la cible. Sous l'action du refroidissement des parois de l'enceinte (6.3) par la circulation d'eau (6.6), cette vapeur se condense sous forme de nanoparticules qui grossissent à mesure qu'elles s'acheminent vers la sortie de la source sous l'effet de la dépression créé par le pompage (6.7) de l'enceinte externe (6.5). Dans l'enceinte (6.5), la pression vaut typiquement 10⁻⁴ mbar alors que celle de l'enceinte (6.6) est de 10⁻¹ mbar. Le détail du fonctionnement de ce type de source est décrit dans l'article E. Quesnel et al., J. Appl. Phys., vol. 107, issue 4 (2010), 054309.

Si dans l'enceinte de dépôt règne une atmosphère légèrement oxydante, les nanoparticules ont tendance à s'oxyder. Comme le titane ou le cérium sont plus avides d'oxygène que le silicium, on retrouve en surface une couche d'oxyde de Ti ou de Ce. Cette technique permet de déposer des particules très petites, typiquement de diamètre compris entre 1 et 10 nm. Dans les conditions de synthèse utilisées, les nanoparticules sont généralement amorphes, mais du fait de leur petite taille, leur recristallisation nécessite des températures de recuit n'excédant pas 700°C. Pour former le nano-composite final comprenant les nano-cristaux de silicium noyés dans une matrice semi-conductrice ou isolante, on dépose les deux en même temps ou par alternance dans une même enceinte de dépôt sous vide.

Cette solution technologique originale est celle qui permet un meilleur contrôle de la taille des nanoparticules.

### Exemple 1 bis : Synthèse directe de nanocristaux de germanium fonctionnalisés + recuit à 400-500°C.

On procède de façon identique au mode opératoire de l'exemple 1 mais en remplaçant Si par Ge.

### Exemple 2 : multicouche ZnO /Ti / Si / Ti / ZnO recuit entre 800 et 1000°C (figure 7).

Il s'agit cette fois d'un mode plus conventionnel de dépôt alterné de couches très fines : [ZnO(3nm) / Ti(1nm) / Si(3nm) / Ti(1nm) / ZnO(3nm)] répété 30 fois. Par souci de simplification, on n'a représenté que quatre alternances de couches sur la figure 7. La couche de Ti a pour effet de réduire l'atmosphère de dépôt de l'enceinte. L'empilement de base est répété 30 fois ce qui conduit à la réalisation d'un absorbeur d'environ 330 nm d'épaisseur.

Le recuit induit une précipitation du Si sous forme de particules allongées dont la hauteur est parfaitement contrôlée. Ce silicium est protégé par l'oxydation du titane et reste à l'état semi-conducteur.

### Exemple 2 bis : multicouche ZnO /Ti / Ge / Ti / ZnO recuit entre 800 et 1000°C.

On procède de façon identique au mode opératoire de l'exemple 2 mais en remplaçant Si par Ge.

### Exemple 3 :

Comme dans l'exemple 1, on génère dans une source à nanoparticules une vapeur binaire composée d'atomes de silicium. Cette vapeur est produite par évaporation ou pulvérisation de Si. Les atomes sont ensuite condensés en phase gazeuse par refroidissement de la vapeur et les nanoparticules ainsi formées sont transportées dans l'enceinte de dépôt annexe pour être projetées sur le substrat à traiter.

Au moyen de ces nanoparticules de silicium, on réalise le dépôt alterné de couches très fines : [ZnO(3nm) / Ti(1nm) / Si(3nm) / Ti(1nm) / ZnO(3nm)]

On termine par un recuit entre 100 et 700°C.

Par rapport au procédé de l'exemple 2, on obtient un meilleur contrôle de la taille des nanoparticules.

## Revendications

1. Matériau comportant une matrice en matériau semi-conducteur ou isolant, transparent, dans laquelle sont dispersées des nanoparticules de type coeur-coquille, dont le coeur est constitué d'un matériau semi-conducteur choisi parmi les matériaux covalents Si, Ge et Si-Ge et les matériaux ioniques de type II-VI ou III-V et la coquille est formée d'un matériau choisi parmi les oxydes TiO₂ et/ou CeO₂.

2. Matériau selon la revendication 1 dans lequel la matrice est en un matériau choisi parmi: SiO₂, SiC, SiNₓ (x≤4/3), In₂O₃, ITO et ZnO, dopé ou non.

3. Matériau selon la revendication 1 ou la revendication 2 dans lequel les nanoparticules ont une taille comprise entre 1 et 30 nm.

4. Matériau selon l'une quelconque des revendications 1 à 3 dans lequel les nanoparticules ont un coeur dont la taille est comprise entre 1 et 25 nm.

5. Matériau selon l'une quelconque des revendications 1 à 4 dans lequel les nanoparticules ont toutes un coeur dont la taille est sensiblement identique.

6. Matériau selon l'une quelconque des revendications 1 à 5 dans lequel le coeur est constitué d'un matériau semi-conducteur choisi parmi : Si, Ge, Si₍₁₋ₓ₎Geₓ avec x un nombre et 0,1≤x≤0,9.

7. Matériau selon l'une quelconque des revendications 1 à 6 dans lequel la concentration des nanoparticules dans la matrice est comprise entre 10¹⁶cm⁻³ et 10¹⁹cm⁻³.

8. Article constitué d'une superposition de couches de matériaux selon l'une quelconque des revendications 1 à 7.

9. Article selon la revendication 8 qui comporte de 1 à 10 couches de matériau selon les revendications 1 à 7.

10. Article selon la revendication 8 ou la revendication 9 dans lequel les couches de matériau superposées comportent toutes des matrices d'un même matériau.

11. Article selon l'une quelconque des revendications 8 à 10 dans lequel les couches de matériau superposées sont toutes à base de nanoparticules constituées des mêmes matériaux.

12. Procédé pour la fabrication des matériaux selon l'une quelconque des revendications 1 à 7 qui comporte les étapes suivantes :
- production dans une source à nanoparticules d'une vapeur binaire composée d'atomes de coeur et d'atomes entrant dans la constitution de la coquille, c'est-à-dire d'atomes de Ti et/ou de Ce ;
- formation de nanoparticules par condensation des atomes en phase gazeuse par refroidissement de la vapeur ;
- transport des nanoparticules ainsi formées dans une enceinte de dépôt ;
- projection sur un substrat ;
- recuit à une température allant de 100°C à 700°C ;
- l'isolant ou le semi-conducteur constituant la matrice est déposé en même temps que les nanoparticules ou par alternance dans la même enceinte de dépôt sous vide.

13. Procédé pour la fabrication des matériaux selon l'une quelconque des revendications 1 à 7 qui comporte les étapes suivantes :
- dépôt alterné de couches très fines, de 0,2 à 5 nm, de matériau suivant la séquence : matériau de matrice / matériau coquille / matériau de coeur / matériau coquille / matériau de matrice ;
- répétition du dépôt alterné suivant la séquence ci-dessus de 10 à 100 fois jusqu'à l'obtention d'un matériau d'épaisseur souhaitée.
- Recuit à une température allant de 800°C à 1000°C

14. Procédé pour la fabrication des matériaux selon l'une quelconque des revendications 1 à 7 qui comporte les étapes suivantes :
- production dans une source à nanoparticules d'une vapeur binaire composée d'atomes de coeur ;
- formation de nanoparticules par condensation des atomes en phase gazeuse par refroidissement de la vapeur ;
- transport des nanoparticules ainsi formées dans une enceinte de dépôt ;
- dépôt alterné de couches très fines, de 0,2 à 5 nm, de matériau suivant la séquence : matériau de matrice / matériau coquille / nanoparticules de coeur / matériau coquille / matériau de matrice ;
- recuit à une température allant de 100°C à 700°C.

15. Procédé selon la revendication 13 ou la revendication 14 dans lequel le dépôt des couches de matériau est fait par un procédé de dépôt chimique en phase vapeur.

16. Utilisation d'un matériau selon l'une des revendications 1 à 7 ou d'un article selon l'une des revendications 8 à 11 pour l'une des applications suivantes: fabrication de cellules photovoltaïques, fabrication de détecteurs ou d'imageurs opto-électroniques, fabrication de supports optiques et/ou magnétiques pour le stockage de données.

## Patentansprüche

1. Material mit einer Matrize aus Halbleitermaterial oder aus isolierendem, transparentem Material, in dem Nanopartikel der Art Kern-Schale verteilt sind, wobei der Kern aus einem Halbleitermaterial besteht, das aus den kovalenten Materialien Si, Ge und Si-Ge und den ionischen Materialien der Art II-VI oder III-V ausgewählt ist, und die Schale aus einem aus den Oxyden TiO₂ und/oder CeO₂ ausgewählten Material gebildet ist.

2. Material nach Anspruch 1, bei dem die Matrize aus einem Material besteht, das aus dotiertem oder nicht dotiertem SiO₂, SiC, SiNₓ (x ≤ 4/3), In₂O₃, ITO und ZnO ausgewählt ist.

3. Material nach Anspruch 1 oder Anspruch 2, bei dem die Nanopartikel eine Größe haben, die zwischen 1 und 30 nm beträgt.

4. Material nach einem der Ansprüche 1 bis 3, bei dem die Nanopartikel einen Kern mit einer Größe aufweisen, die zwischen 1 und 25 nm beträgt.

5. Material nach einem der Ansprüche 1 bis 4, bei dem die Nanopartikel alle einen Kern mit einer im Wesentlichen identischen Größe aufweisen.

6. Material nach einem der Ansprüche 1 bis 5, bei dem der Kern aus einem Halbleitermaterial besteht, das aus Si, Ge, Si(₁₋ₓ₎Geₓ, wobei x eine Zahl ist und 0,1 ≤ x ≤ 0,9, ausgewählt ist.

7. Material nach einem der Ansprüche 1 bis 6, bei dem die Konzentration der Nanopartikel in der Matrize zwischen 10¹⁶ cm⁻³ und 10¹⁹ cm⁻³ beträgt.

8. Artikel, der aus einer Übereinanderlagerung von Schichten aus Materialien nach einem der Ansprüche 1 bis 7 besteht.

9. Artikel nach Anspruch 8, der 1 bis 10 Schichten aus Materialien nach einem der Ansprüche 1 bis 7 aufweist.

10. Artikel nach Anspruch 8 oder Anspruch 9, bei dem die übereinanderliegenden Materialschichten alle Matrizen aus dem gleichen Material aufweisen.

11. Artikel nach einem der Ansprüche 8 bis 10, bei dem die übereinanderliegenden Materialschichten alle auf Basis von Nanopartikeln sind, die aus den gleichen Materialien bestehen.

12. Verfahren zur Herstellung der Materialien nach einem der Ansprüche 1 bis 7, das folgende Schritte umfasst:
- Erzeugung eines binären Dampfes in einer Nanopartikelquelle, der aus Kernatomen und aus Atomen, die in die Struktur der Schale eingehen, d.h. aus Ti- und/oder aus Ce-Atomen besteht;
- Bildung von Nanopartikeln durch Kondensation der Atome in der Gasphase durch Abkühlung des Dampfes;
- Transportieren der so gebildeten Nanopartikel in eine Abscheidungskammer;
- Spritzen auf ein Substrat;
- Glühen bei einer Temperatur von 100°C bis 700°C;
- das Isoliermaterial oder der Halbleiter, das bzw. der die Matrize bildet, wird gleichzeitig mit den Nanopartikeln oder abwechselnd in der gleichen Vakuum-Abscheidungskammer abgeschieden.

13. Verfahren zur Herstellung der Materialien nach einem der Ansprüche 1 bis 7, das folgende Schritte umfasst:
- abwechselnde Abscheidung von sehr dünnen Materialschichten von 0,2 bis 5 nm in der Reihenfolge: Matrizenmaterial / Schalenmaterial / Kernmaterial / Schalenmaterial / Matrizenmaterial;
- 10- bis 100-fache Wiederholung der abwechselnden Abscheidung in der oben genannten Reihenfolge, bis ein Material mit der gewünschten Dicke erhalten wird;
- Glühen bei einer Temperatur von 800°C bis 1000°C.

14. Verfahren zur Herstellung der Materialien nach einem der Ansprüche 1 bis 7, das folgende Schritte umfasst:
- Erzeugung eines aus Kernatomen bestehenden binären Dampfes in einer Nanopartikelquelle;
- Bildung von Nanopartikeln durch Kondensation der Atome in der Gasphase durch Abkühlung des Dampfes;
- Transportieren der so gebildeten Nanopartikel in eine Abscheidungskammer;
- abwechselnde Abscheidung von sehr dünnen Materialschichten von 0,2 bis 5 nm in der Reihenfolge: Matrizenmaterial / Schalenmaterial / Nanopartikel-Kernmaterial / Schalenmaterial / Matrizenmaterial;
- Glühen bei einer Temperatur von 100°C bis 700°C.

15. Verfahren nach Anspruch 13 oder Anspruch 14, bei dem die Abscheidung der Materialschichten mittels eines Gasphasenabscheidungsverfahrens erfolgt.

16. Verwendung eines Materials nach einem der Ansprüche 1 bis 7 oder eines Artikels nach einem der Ansprüche 8 bis 11 für eine der nachfolgenden Anwendungen: Herstellung von photovoltaischen Zellen, Herstellung von optoelektronischen Detektoren oder Bildgeräten und Herstellung von optischen und/oder magnetischen Trägern zur Datenspeicherung.

## Claims

1. A material including a matrix of a transparent semiconductor or insulating material in which are dispersed core-shell type nanoparticles, the core of which is composed of a semiconductor material selected from covalent materials Si, Ge and Si-Ge and ionic materials of type II-VI or III-V and the shell of which is formed of a material selected from the oxide(s) TiO₂ and/or CeO₂.

2. Material according to claim 1 wherein the matrix is composed of a material selected from SiO₂, SiC, SiNₓ (x ≤ 4/3), In₂O₃, ITO and ZnO, doped or undoped.

3. Material according to claim 1 or claim 2 wherein the nanoparticles have a size between 1 and 30 nm.

4. Material according to any one of claims 1 to 3 wherein the nanoparticles have a core whose size is between 1 and 25 nm.

5. Material according to any one of claims 1 to 4 wherein the nanoparticles all have a core whose size is substantially identical.

6. Material according to any one of claims 1 to 5 wherein the core is composed of a semiconductor material selected from Si, Ge, Si₍₁₋ₓ₎Geₓ where x is a number and 0.1 ≤ x ≤ 0.9.

7. Material according to any one of claims 1 to 6 wherein the concentration of nanoparticles in the matrix is between 10¹⁶ cm⁻³ and 10¹⁹ cm⁻³.

8. Article composed of a superposition of layers of materials according to any one of claims 1 to 7.

9. Article according to claim 8 which includes to 10 layers of material according to claims 1 to 7.

10. Article according to claim 8 or claim 9 wherein the superposed layers of material all include matrices composed of the same material.

11. Article according to any one of claims 8 to 10 wherein the superposed layers of material are all based on nanoparticles composed of the same materials.

12. Method for producing materials according to any one of claims 1 to 7 which includes the following steps:
- production in a nanoparticle source of a binary vapour composed of core atoms and atoms forming part of the shell, that is to say Ti and/or Ce atoms;
- formation of nanoparticles by condensation of the atoms in the gas phase by cooling of the vapour;
- transport of the nanoparticles formed in this way to a deposition chamber;
- projection onto a substrate;
- annealing at a temperature ranging from 100°C to 700°C;
- the insulating or semiconductor material constituting the matrix is deposited at the same time as the nanoparticles or alternately in the same vacuum deposition chamber.

13. Method for producing materials according to any one of claims 1 to 7 which includes the following steps:
- alternate deposition of very thin layers of 0.2 to 5 nm, of material in the following sequence: matrix material/shell material/core material/shell material /matrix material;
- repeating the alternating deposition according to the above sequence 10 to 100 times until a material of desired thickness of is obtained.
- annealing at a temperature ranging from 800°C to

14. Method for producing materials according to any one of claims 1 to 7 which includes the following steps:
- production in a nanoparticle source of a binary vapour composed of core atoms;
- formation of nanoparticles by condensation of the atoms in the gas phase by cooling of the vapour;
- transport of the nanoparticles formed in this way to a deposition chamber;
- alternate deposition of very thin layers of 0.2 to 5 nm, of material in the following sequence: matrix material/shell material/core nanoparticles/shell material /matrix material;
- annealing at a temperature ranging from 100°C to 700°C.

15. Method according to claim 13 or claim 14 wherein the deposition of the layers of material is done by a chemical vapour deposition process.

16. Use of a material according to any one of claims 1 to 7 or an article according to any one of claims 8 to 11 for any one of the following applications: manufacture of photovoltaic cells, manufacture of optoelectronic sensors or imaging devices, manufacture of optical and/or magnetic media for data storage.
